Europäisches Patentamt

European Patent Office

Office européen des brevets

(19)

(11) Veröffentlichungsnummer: **0 029 577**
**B1**

(12) **EUROPÄISCHE PATENTSCHRIFT**

(45) Veröffentlichungstag der Patentschrift:
27.04.83

(51) Int. Cl.³: **H 05 K 7/20**

(21) Anmeldenummer: **80107173.9**

(22) Anmeldetag: **19.11.80**

(54) Zur staubfreien Kühlung eines Schaltschrankes dienender Wärmetauscher.

(30) Priorität: **27.11.79 DE 2947687**

(43) Veröffentlichungstag der Anmeldung:
**03.06.81 Patentblatt 81/22**

(45) Bekanntmachung des Hinweises auf die Patenterteilung:
**27.04.83 Patentblatt 83/17**

(84) Benannte Vertragsstaaten:
**AT BE CH FR GB IT LI LU NL SE**

(56) Entgegenhaltungen:
**DE-A-2 006 759**
**DE-U-1 860 641**
**US-A-2 820 616**
**US-A-3 559 728**

(73) Patentinhaber: **Autz + Herrmann Metallwaren- und Maschinenfabrik, Karl-Benz-Strasse 10-12, D-6900 Heidelberg1 (DE)**

(72) Erfinder: **Reinhard, Heinrich, Husarenstrasse 5, D-6900 Heidelberg (DE)**

(74) Vertreter: **Patentanwälte Dipl.-Ing. W. Scherrmann Dr.-Ing. R. Rüger, Webergasse 3 Postfach 348, D-7300 Esslingen (Neckar) (DE)**

Zur staubfreien Kühlung eines Schaltschrankes dienender Wärmetauscher

Die Erfindung betrifft einen zur staubfreien Kühlung eines Schaltschrankes mittels durch Gebläse geförderter Kühlluft dienenden und aussen an der Schrankwand angeordneten Wärmetauscher mit flachen, dem einen durch den Schaltschrank hindurchgehenden Kühlluftkreislauf zugeordneten Kanälen, zwischen denen flache, zu dem anderen mit der Aussenluft verbundenen Kühlluftkreislauf gehörende Kanäle wärmeübertragend angeordnet sind.

Aus der DE-AS 2 006 759 ist ein Wärmetauscher der obigen Art bekannt, bei dem eine Seitenwand oder eine Tür aus einem mäanderförmig gebogenen Blech besteht, so dass hierdurch Kanäle für die Kühlmittel gebildet sind, die im übrigen durch das mäanderförmige Blech voneinander getrennt sind, damit eine staubfreie Kühlung für die im Inneren des Elektronikschrankes angeordneten Bauelemente möglich ist.

Die durch das mäanderförmige Blech gebildeten Knäle sind nicht abgeschlossen, so dass die Luft jederzeit längs ihres Weges durch die Falten aus diesen austreten kann, womit sich keine besonders gute Luftführung ergibt. Ausserdem ist ein derartiges mäanderförmiges Blech sehr schwierig mit der erforderlichen Genauigkeit herzustellen, wenn die einzelnen Falten nacheinander gebogen werden. Andererseits ist es aber aus Kostengründen praktisch nicht möglich, derart grosse mäanderförmige Bleche für die Luftkühlung von Schaltschränken mit einem Werkzeug in einem Arbeitsgang auszuformen.

Ein solches mäanderförmig gebogenes Blech, das die eigentliche Wärmeaustauschfläche bildet, ist auch bei einem anderen, aus der US-A 3559 728 bekannten, aussen an einer Wand eines Schaltschrankes anzubringenden Wärmetauscher vorhanden. Die Anordnung ist hierbei derart getroffen, dass der Wärmetauscher ein bspw. mittels eines Scharnierbandes an dem Schaltschrank zu befestigendes kastenartiges Gehäuse aufweist, das durch das mäanderförmig gebogene Blech in zwei Kammern unterteilt ist, von denen jede ein in dem kastenartigen Gehäuse untergebrachtes Gebläse enthält. Die eine der Kammern ist dem durch den Schaltschrank hindurchgehenden Kühlluftkreislauf zugeordnet, während die andere Kammer in dem mit der Aussenluft verbundenen anderen Kühlluftkreislauf liegt. Damit ist zwar auch eine staubfreie Luftkühlung des Schaltschrankes gewährleistet, doch ist das mäanderförmig gebogene Blech, insbesondere auf der dem mit der Aussenluft verbundenen Kühlluftkreislauf zugeordneten Seite auch nach dem Abschwenken des Gehäuses von dem Schaltschrank der Reinigung nicht leicht zugängig. Für die Reinigung ist es erforderlich, das kastenartige Gehäuse zu zerlegen, wozu u.U. auch das unmittelbar neben dem mäanderförmigen Blech angeordnete Gebläse des mit der Aussenluft verbundenen Kühlluftkreislaufes demontiert werden muss. Davon abgesehen, ist die für die Wärmeübertragung zwischen den beiden Kühlluftkreisläufen zur Verfügung stehende wärmeaustauschende Fläche verhältnismässig begrenzt, was bedeutet, dass für eine betimmte zu übertragende Wärmemenge ein Wärmetauscher mit einem verhältnismässig grossen Platzbedarf erforderlich ist.

Es ist auch schon ein allseitig von einem Gehäuse umgebener Wärmetauscher, vorzugsweise für eine Luftentfeuchtungsanlage, bekannt geworden, bei dem die Kanäle des Wärmetauschers aus zu einem Paket zusammengefügten gleichen Platten mit hochgebogenen seitlichen Rändern und einem an einer Stirnseite hochgebogenen Rand gebildet sind (DE-GM 1 860 641). An den seitlichen Rändern der Platten sind in der Nachbarschaft des stirnseitigen Randes der Platten Ausnehmungen vorgesehen. Die aufeinanderfolgenden Platten des Paketes sind derart entgegengesetzt gegeneinander ausgerichtet, dass die seitlichen Ausnehmungen aufeinanderfolgender Platten jeweils an einem anderen Ende des Wärmetauschers zu liegen kommen. Wie gesagt, ist jedoch das Plattenpaket in einem allseitig geschlossenen Gehäuse angeordnet, aus dem die Luft von beiden Seiten durch die seitlichen Ausnehmungen, in die die erste Wärmezone bildenden hochgebogenen Platten einströmt. Durch die offene Stirnseite der Platten gelangt die Luft zu einem Verdampfer, von dem sie in einen anderen Teil des Gehäuses einströmt, aus dem sie wiederum durch die seitlichen Ausnehmungen in die Kanäle der zweiten Wärmezone gelangt, worauf sie den Wärmetauscher entfeuchtet verlässt. Bei diesem bekannten Wärmetauscher wird daher ein und derselbe Luftstrom wärmemässig beeinflusst. Es handelt sich somit um einen Einkreiswärmetauscher. Da er allseitig von einem Gehäuse umgeben ist, ist die Reinigung und die Montage der ihn zusammensetzenden Platten mit den hochgebogenen Rändern erschwert.

Aufgabe der Erfindung ist est, einen Wärmetauscher zur staubfreien Luftkühlung von Schaltschränken zu schaffen, der bei einfachem Aufbau bei Montage und Reinigung an dem Schaltschrank leicht zugänglich ist und der an dem Schaltschrank möglichst wenig Raum beansprucht.

Zur Lösung dieser Aufgabe ist der erfindungsgemässe Wärmetauscher durch die Kombination der Merkmale des Patentanspruches gekennzeichnet.

Die durch die Erfindung erreichten Vorteile sind im wesentlichen darin zu sehen, dass nunmehr für einen Schaltschrank ein ein geschlossenes Bauelement darstellender Wärmetauscher zur Verfügung steht, der ohne an dem Schaltschrank, wie dies erwünscht ist, einen grösseren Raum einzunehmen, eine einwandfreie Luftführung gewährleistet und mit einem guten Wirkungsgrad arbeitet.

In der Zeichnung ist ein Ausführungsbeispiel des Gegenstandes der Erfindung dargestellt. Es zeigen

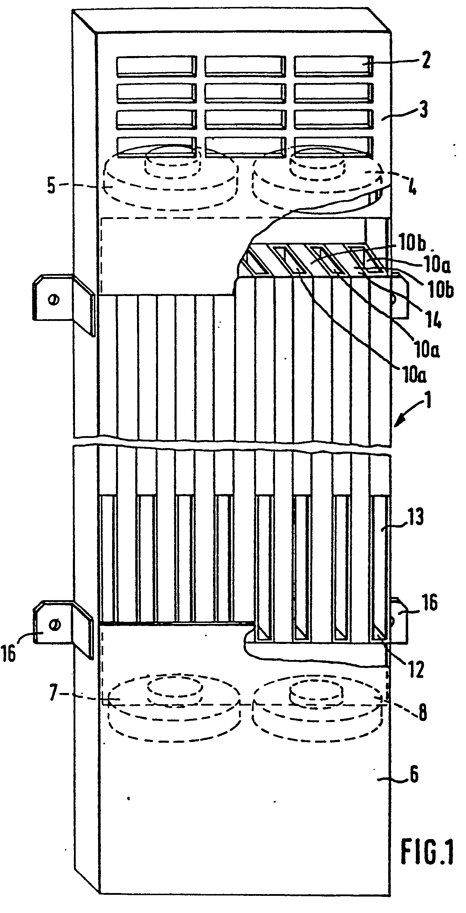

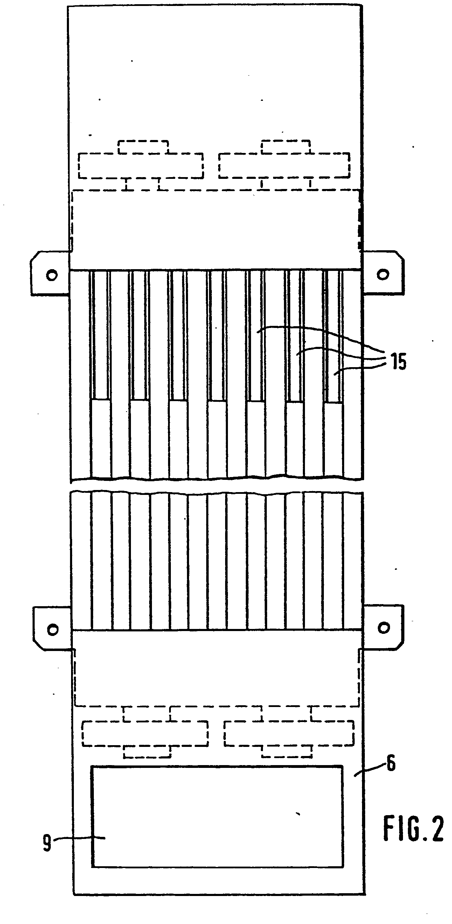

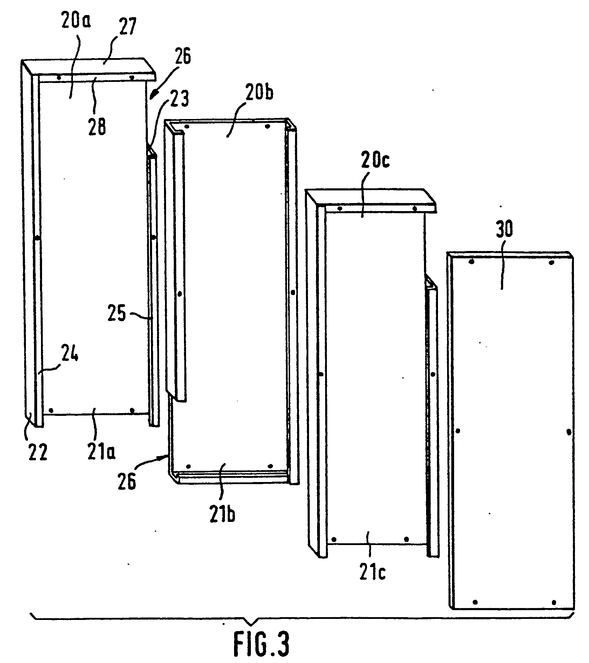

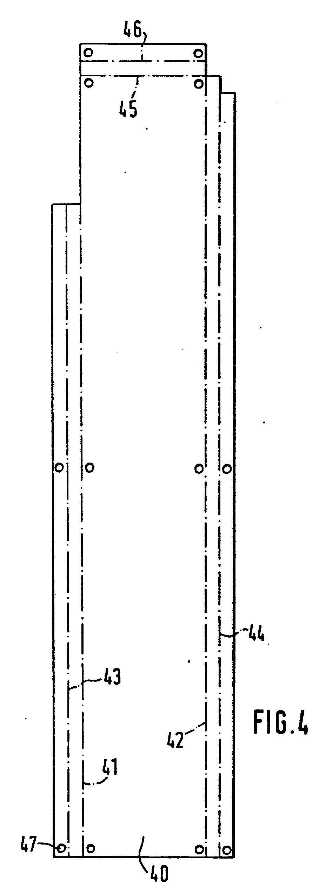

Figur 1 einen Wärmetauscher gemäss der Erfindung, mit auf beiden Stirnseiten aufgesetzten, Lüfter enthaltenden Kästen, in einer gekürzten perspektivischen Vorderansicht, Figur 2 den Wärmetauscher nach Figur 1 in einer Rückansicht, Figur 3 die abgebogenen Platten eines Teiles des Wärmetauschers nach Figur 1 in einem anderen Massstab und in einer auseinandergezogenen Teildarstellung und Figur 4 einen Blechzuschnitt für eine abgebogene Platte mit den entsprechenden Abkantlinien in einer Draufsicht.

In Figur 1 ist ein Wärmetauscher 1 für zwei Kühlluftkreisläufe dargestellt, der zur staubfreien Luftkühlung eines Schaltschrankes dient. Auf seiner oberen Stirnseite sitzt ein mit die Verbindung mit der Aussenluft herstellenden Lüftungsschlitzen 2 versehener Kasten 3, in dem zwei durch gestrichelte Linien angedeutete Lüfter 4 und 5 angeordnet sind. Auf der unteren Stirnseite des Wärmetauschers 1 befindet sich ein weiterer Kasten 6, in dem ebenfalls zwei gestrichelt angedeutete Lüfter 7 und 8 enthalten sind. Der untere Kasten 6 weist, wie Figur 2 zeigt, eine Öffnung 9 auf, die jedoch in die entgegengesetzte Richtung wie die Lüftungsschlitze 2 des oberen Kastens 3 weist und die Verbindung mit dem Inneren des Schaltschrankes herstellt.

Der Wärmetauscher 1 ist durch abwechselnd nebeneinander angeordnete Kanäle 10a und 10b gebildet. Die Kanäle 10a sind nach oben in Richtung auf den Kasten 3 offen und nach unten in Richtung auf den Kasten 6 stirnseitig bei 12 verschlossen, während sie an diesem Ende eine seitliche Öffnung 13 aufweisen, durch die die von den Lüftern 4 und 5 in die Kanäle 10a eingeblasene Luft zur Aussenluft zurückkehren kann. Die Kanäle 10b sind an ihrem in dem Kasten 3 befindlichen Ende bei 14 abgeschlossen und enthalten, wie Figur 2 zeigt, seitliche, nach hinten in den Schaltschrank weisende Öffnungen 15, während sie an dem in dem Kasten 6 befindlichen Ende offen sind. Auf diese Weise kann die von den Lüftern 7 und 8 des unteren Kastens 6 in die Kanäle 10b eingeblasene Luft über die Öffnungen 15 in den Schaltschrank austreten.

Mit Hilfe von an dem Wärmetauscher 1 angebrachten Flanschen ist er an dem Schaltschrank zu befestigen, wonach die Öffnungen 15 und die Öffnung 9 strömungsmässig mit dem Inneren des Schaltschrankes verbunden sind, während die Lüftungsschlitze 2 sowie die Öffnungen 13 mit der Aussenluft in Verbindung stehen.

Die Kanäle 10a und 10b sind jeweils durch Platten 20 gebildet, die aus einem Boden 21 und zwei seitlich abgebogenen Rändern 22 und 23 bestehen, an die nach innen weisende Leisten 24 und 25 angeformt sind. Der Rand 23 ist an einem Ende der Platte 20 verkürzt, so dass eine Ausnehmung 26 zustandekommt, die ihrerseits beim Zusammenbau der einzelnen Platten die Öffnung 13 bzw. 15 bildet. Jeweils im Bereich der Ausnehmung 26 ist jede der Platten 20 mit einem stirnseitigen Rand 27 versehen, der ebenfalls eine angebogene Leiste 28 trägt.

Wie aus Figur 3 ersichtlich, sind alle Platten 20, die gemeinsam den Wärmetauscher 1 bilden, untereinander gleich, jedoch um eine zum Boden 21 rechtwinklig verlaufende Achse um 180° gedreht, so dass die Ausnehmung 26 bei jeder zweiten Platte 20 oben angeordnet ist und, bezogen auf Figur 3, nach rechts weist, während die Ausnehmung 26 der jeweils dazwischen angeordneten Platte 20 unten liegt und, bezogen auf Figur 3, nach links weist.

Beim Zusammenbau des Wärmetauschers 1 wird auf der Plate 20a, deren Ausnehmung 26 oben liegt, die Platte 20b derart angeordnet, dass ihr Boden 21b auf den Leisten 24, 25 der abgebogenen Ränder 22, 23 zu liegen kommt. Die Ausnehmung 26 der Platte 20b liegt hierbei unten. Auf die Platte 20b wird bei der weiteren Montage die Platte 20c aufgesetzt, die wiederum dieselbe Ausrichtung hat wie die Platte 20a. Wenn grössere Leistungen abgeführt werden müssen, können weitere Platten 20 abwechselnd mit den Ausnehmungen 26 oben oder unten nebeneinander angeordnet werden. Die jeweils letzte noch gebogene Platte, in Figur 3 die Platte 20c, ist durch eine einfache ebene Platte 30 abgeschlossen.

Durch die abwechselnde Anordnung der Platten 20 ergeben sich die Kanäle 10a und 10b des Wärmetauschers 1, die jweils durch die hochgebogenen Ränder 22 und 23 sowie den Boden 21 einer Platte 20 und den Boden 21 der jeweils benachbarten Platte 20 begrenzt sind. Ausserdem ergeben sich durch die abwechselnde Anordnung der Platten 20 abwechselnd die nach oben bzw. nach unten offenen Kanäle 10a und 10b für die voneinander getrennten Kühlluftströme.

In Figur 4 ist ein Blechzuschnitt in Gestalt eines Blechstreifens 40 mit Biegelinien 41, 42, 43, 44 gezeigt, aus dem die für den Wärmetauscher 1 erforderlichen Platten 20 hergestellt sind. Durch Abkanten des Blechstreifens 40 entlang den Biegelinien 41 und 42 entstehen die hochgebogenen Ränder 22 und 23; durch weiteres Abkanten entlang den Biegelinien 43 und 44 entstehen die umgebogenen Leisten 24 und 25, während durch Abkanten entlang der Biegelinien 45 und 46 der stirnseitige Rand des jeweiligen Kanals hergestellt wird. Bereits vor dem Abkanten werden in dem Blechstreifen 40 Bohrungen 47 angebracht, durch die später Zugbolzen führen, welche die einzelnen Platten 20 des Wärmetauschers 1 zusammenhalten. Die Leisten 24 und 25 verbessern hierbei die gegenseitige Abdichtung der einzelnen Platten 20. Anstelle von Zugbolzen, die die einzelnen Platten miteinander verbinden, können sie auch unlösbar durch Schweissen oder Kleben verbunden werden. Auch ist es möglich, die z.B. aus Kunststoff bestehenden Platten 20 miteinander zu verkleben, um die Dichtheit zu verbessern.

**Patentanspruch**

Zur staubfreien Kühlung eines Schaltschrankes mittels durch Gebläse geförderter Kühlluft dienender und aussen an der Schrankwand angeordneter Wärmetauscher mit flachen, dem einen durch den Schaltschrank hindurchgehenden Kühlluftkreislauf zugeordneten Kanälen, zwischen denen flache, zu dem anderen mit der Aussenluft verbundenen Kühlluftkreislauf gehörende Kanäle wärmeübertragend angeordnet sind, gekennzeichnet durch die Kombination folgender Merkmale:

a) Die Kanäle (10a, 10b) des Wärmetauschers (1) sind aus zu einem Paket zusammengefügten gleichen Platten (20) mit an zwei gegenüberliegenden Plattenkanten hochgebogenen Rändern (22, 23) und mit einem an einer der beiden Stirnseiten hochgebogenen Rand (28) gebildet, wobei das Paket durch eine auf den hochgebogenen Rändern der letzten Platte aufliegende ebene Platte (30) abgeschlossen ist,

b) an dem einen seitlichen Rand (23) jeder Platte ist in der Nachbarschaft des stirnseitigen Randes (28) der Platte (20) eine Ausnehmung (26) vorgesehen,

c) die aufeinanderfolgenden Platten (20) des Paketes sind gegeneinander um 180° um eine zur Plattenebene senkrechte, durch den Schnittpunkt der Plattendiagonalen verlaufende Achse verdreht,

d) das Plattenpaket ist derart angeordnet, dass die Plattenebenen senkrecht auf der Wand des Schaltschrankes stehen,

e) auf die einander gegenüberliegenden, von den Stirnseiten der Platten gebildeten Flächen des Paketes, sind jeweils Gebläse (4, 5, 7, 8) enthaltende Kästen (3, 6) aufgesetzt,

f) diejenigen hochgebogenen Ränder der Platten (20), deren Ausnehmungen (13) der Aussenluft zugewandt sind, stehen über ihre randfreien Stirnenden mit einem Kasten (3) in Verbindung, der seinerseits zur Aussenluft führende Öffnungen (2) aufweist,

g) diejenigen hochgebogenen Ränder der Platten (20), deren Ausnehmungen (15) dem Schaltschrank zugewandt und mit dessen Innerem verbunden sind, stehen mit ihren randfreien Stirnenden mit einem Kasten (6) in Verbindung, der seinerseits über eine Öffnung (9) mit dem Inneren des Schaltschrankes verbunden ist.

## Claim

A heat exchanger, adapted to be mounted on the outer side of a wall of an electronic circuit cabinet, for the dust-free cooling of said electronic circuit cabinet by means of cooling air supplied by blower means, comprising narrow ducts associated with a cooling air flow circuit passing through the interior of the electronic circuit cabinet and further narrow ducts forming part of another cooling air flow circuit in communication with the ambient air, said other ducts being interposed in a heat transferring relationship between said one ducts, characterized by the combination of the following features:

a) The ducts (10a, 10b) of the heat exchanger (1) are defined by identical plates (20), stacked to form a package, each of said plates (20) having angled-off edge portions (22, 23) located at two opposite edges of the plate and having an angled-off edge portion (28) at one of its two end sides, the package being closed off by a plane plate (30) that is positioned on the angled-off edge portions of the last plate of the stack,

b) at one lateral side (23) of each plate there is provided a notch (26) in the vicinity of the end side edge (28) of the plate,

c) adjacent plates (20) of the package are 180°-reversely orientated to each other with respect to an axis that extends normal to the major plane of the plates and through the point of intersection of the two diagonals of each of the plates,

d) the package of plates is arranged in such a way that its plates extend at right angles to a wall of the electronic circuit cabinet,

e) manifold-boxes (3,6), each retaining blower means (4, 5, 7, 8), are positioned on the end portions of said package, said end portions being formed by the front sides of the plates,

f) those angled-off edge portions of the plates (20), the notches (13) of which are facing ambient air,are at their open endportions in flow communication with a manifold-box (3) having openings that lead into ambient air,

g) those angled-off edge portions of the plates (20), the notches (15) of which are facing the interior of the electronic circuit cabinet and in flow communication therewith, are at their open end portions in flow communication with a manifold-box (6), having an opening (9) that leads into the interior of the electronic circuit cabinet.

## Revendication

Echangeur de chaleur pour le refroidissement sans poussières d'une armoire comprenant un appareillage électrique au moyen d'air de refroidissement soufflé par des ventilateurs, et disposé contre la paroi de l'armoire extérieurement à celle-ci, ledit échangeur de chaleur comportant une première série de canaux plats associés à l'un des circuits d'air de refroidissement traversant l'armoire électrique, entre lesdits canaux plats de cette première série étant disposés pour un transfert de chaleur, une seconde série de canaux plats appartenant à l'autre circuit d'air de refroidissement connecté à l'air extérieur, caractérisé par la combinaison de la combinaison de caractéristiques suivantes:

a) Les canaux (10a, 10b) de l'échangeur de chaleur (1) sont formés à partir de plaques (20) identiques rassemblées en un paquet et comportant des bords (22, 23) redressés sur deux arêtes opposées, et un bord (28) redressé sur l'un des deux côtés frontaux, le paquet de plaques étant obturé par une plaque (30) plane reposant sur les bords redressés de la dernière plaque dudit paquet,

b) sur l'un des bords (23) latéraux de chaque plaque, est prévu un évidement (26) au voisinage du bord (28) de la plaque (20) situé du côté du frontal,

c) les plaques (20) successives du paquet sont mutuellement tournées de 180° autor d'un axe perpendiculaire au plan des plaques et traversant le point de croisement des diagonales desdites plaques,

d) le paquet de plaques est disposé de façon que les plans des plaques se trouvent perpendiculaires à la paroi de l'armoire électrique,

e) sur les surfaces du paquet, mutuellement oposées, formées par les côtés frontaux des plaques, sont montés respectivement des caissons (3, 6) renfermant des ventilateurs (4, 5, 7, 8),

f) les bords redressés des plaques (20), dont les évidements (13) sont tournés vers l'air extérieur, se trouvent en communication par leurs extrémités frontales dépourvues de bord, avec un caisson (3) qui présente pour sa part des ouvertures (2) débouchant à l'air extérieur,

g) les bords redressés des plaques (20), dont les évidements (15) sont tournés vers l'armoire électrique et communiquent avec l'intérieur de cette dernière, se trouvent en communication par leurs extrémités frontales dépourvues de bord, avec un caisson (6) qui communique pour sa part par une ouverture (9) avec l'intérieur de ladite armoire électrique.

1/4

FIG.1

FIG.2

FIG.3

FIG.4